# EUROPEAN PATENT APPLICATION

(11) **EP 4 376 079 A1**
(43) Date of publication of application: **29.05.2024**
(21) Application number: 22209619.0
(22) Date of filing: 25.11.2022
(51) Int. Cl.: H01L 27/02, H01L 29/87

(54) **A SEMICONDUCTOR DEVICE**

(71) Applicant: Nexperia B.V., 6534 AB Nijmegen (NL)
(72) Inventor: Kumar, Vasantha, 22529 Hamburg (DE); Ritter, Hans-Martin, 22529 Hamburg (DE)
(74) Representative: Pjanovic, Ilija

(57) **Abstract**

According to a first example of the disclosure, a semiconductor device is proposed, which comprises a first layer doped with a first type of charge carriers; a second layer doped with a second type of charge carriers different from the first type of charge carriers; a third layer doped with the first type of charge carriers; a fourth layer doped with the second type of charge carriers; and an input terminal electrically connected with the first layer and an output terminal electrically connected with the fourth layer.

The first, second and third layer form a first bipolar junction transistor, BJT, and the second, third and fourth layer form a second bipolar junction transistor, BJT. Additionally, a junction element is provided which electrically connects the second layer with the third layer. Furthermore, the third layer comprises a high dopant region adjoining the second layer.

The electrical junction element functions as a short between the two base contacts of each BJT. It reduces the trigger voltage to the equivalent of two forward biased diodes. When the device gets triggered, both emitter base junctions, between the first-second layer and fourth-third layer, are forward biased at the same time. Injection of minority carriers starts from both sides and the turn-on effect is fast. At least one of the emitter base junctions has a low capacitance, therefore, the semiconductor controlled rectifier has a low capacitance, too.

## Description

### TECHNICAL FIELD

The present disclosure relates to the field of semiconductor controlled rectifier devices.

### BACKGROUND OF THE DISCLOSURE

Off-chip protection devices for modern circuits with low supply voltage and fast data rates must be optimized for low capacitance, low trigger voltage, fast turn-on, and low on-resistance. The existing devices - mostly based on semiconductor controlled rectifiers, SCR, with complex trigger structures - fail to achieve all four targets at the same time.

From US-B2-9,368,486B2 a DCSCR (directly connected semiconductor controlled rectifier) is known, which however fails to disclose low capacitance capabilities.

Accordingly, it is a goal of the present disclosure to provide an improved semiconductor controlled rectifier device obviating the above sketched issues.

### SUMMARY OF THE DISCLOSURE

According to a first example of the disclosure, a semiconductor device is proposed, which comprises a first layer doped with a first type of charge carriers; a second layer doped with a second type of charge carriers different from the first type of charge carriers; a third layer doped with the first type of charge carriers; a fourth layer doped with the second type of charge carriers; and an input terminal electrically connected with the first layer and an output terminal electrically connected with the fourth layer.

The first, second and third layer form a first bipolar junction transistor, BJT, and the second, third and fourth layer form a second bipolar junction transistor, BJT. Additionally, a junction element is provided which electrically connects the second layer with the third layer. Furthermore, the third layer comprises a high dopant region adjoining the second layer.

The electrical junction element may function as a short between the two base contacts of each BJT. It reduces the trigger voltage to the equivalent of two forward biased diodes. When the device gets triggered, both emitter base junctions, between the first-second layer and fourth-third layer, are forward biased at the same time. Injection of minority carriers starts from both sides and the turn-on effect is fast. At least one of the emitter base junctions has a low capacitance, therefore, the semiconductor controlled rectifier has a low capacitance, too.

In an additional example, the electrical junction element may function as a resistor between the two base contacts of each BJT.

In a further example of a semiconductor device according to the disclosure, the third layer comprises a low dopant region adjoining the high dopant region of the third layer as well as adjoining the fourth layer. It is noted that in this example, the doping of the high dopant region is higher than the doping of the low dopant region. Accordingly, as one emitter, formed by the fourth layer, is connected with or placed in a low doped part of its adjacent base, and therefore, this emitter-base junction has a low capacitance, and consequentially the semiconductor controlled rectifier exhibits beneficially a low capacitance. This obviated the use of an additional trigger diode. Therefore, sophisticated isolation schemes to inhibit the parasitic interactions between the external trigger diode and the semiconductor controlled rectifier are not needed, resulting in a simplified, yet effective configuration.

In a further advantageous example, the second layer comprises a high dopant region adjoining the high dopant region of the third layer and a low dopant region adjoining the first layer, wherein the doping of the high dopant region is higher than the doping of the low dopant region. With this example, both emitters (formed by the first and fourth layers) are positioned in low doped base areas. Both emitter-base junctions exhibit a low capacitance, and due to the series connection of both low-capacitance emitter-base junctions, the total capacitance of the semiconductor device is small too.

In yet another beneficial example of a semiconductor device according to the disclosure, the fourth layer comprises a high dopant region adjoining the output terminal and a low dopant region adjoining the third layer, wherein the doping of the high dopant region is higher than the doping of the low dopant region. Likewise, the emitter-base junction thus formed also exhibits a low capacitance

It should be noted that the first type of charge carriers may be P-type carriers, whereas the second type of charge carriers may be N-type carriers. However, the reversed configuration, wherein the first type of charge carriers are N-type carriers and the second type of charge carriers are P-type carriers is equally appliable in achieving the desired effect of creating one of both of the emitter base junctions having a low capacitance.

Beneficial examples as to the high doping used may include a high dopant region having a doping greater than 1×10¹⁵ cm⁻³ and a layer thickness greater than 0.2 µm, more in particular a doping greater than 1×10¹⁶ cm⁻³ and a layer thickness greater than 1 µm. Likewise, as to the low doping, the low dopant region may have a doping smaller than 1×10¹⁵ cm⁻³ and a layer thickness greater than 1 µm, more in particular a doping smaller than 1×10¹⁴ cm⁻³ and a layer thickness greater than > 2 µm.

Preferably, the first layer has a doping higher than the doping of the low dopant region of the third layer.

In advantageous examples of the semiconductor device according to the disclosure, the fourth layer is formed as a well in the low dopant region of the third layer. Likewise, the high dopant region of the third layer may be formed as a well in the low dopant region of the third layer. And the second layer may be formed as a well in the high dopant region of the third layer, whereas the first layer is formed as a well in the second layer. Accordingly, such semiconductor device can be manufactured in a logical sequence of manufacturing steps.

In a preferred example, the first, second, third and fourth layer are configured in a layered stack. More in particular, a trench is formed in the layered stack extending from/through the fourth layer into at least the second layer, and the junction element is configured as an electrically conductive layer coating the trench. In this configuration the electrically conductive layer functions as an electrical short between the second and the third layer.

Alternatively, an oxide substrate may be used on which the third layer is deposited.

### BRIEF DESCRIPTION OF THE DRAWINGS

The disclosure will now be discussed with reference to the drawings, which show in:
Figure 1a-1c schematic configurations of a first example of a semiconductor device according to the disclosure;
Figure 2 another view of the first example of a semiconductor device according to the disclosure as depicted in Figure 1a;
Figure 3 schematic a second example of a semiconductor device according to the disclosure;
Figure 4 another view of the second example of a semiconductor device according to the disclosure as depicted in Figure 3;
Figure 5 a third example of a semiconductor device according to the disclosure;
Figure 6 another view of the third example of a semiconductor device according to the disclosure;
Figure 7 a fourth example of a semiconductor device according to the disclosure;
Figure 8 a fifth example of a semiconductor device according to the disclosure;
Figure 9 a sixth example of a semiconductor device according to the disclosure;
Figures 10a 10b another views of the sixth example of a semiconductor device according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

For the sake of clarity, it is noted that in this application several examples of semiconductor devices according to the disclosure are depicted, whose configuration is formed of layers, which are doped with a first type of charge carriers or with a second type of charge carriers, wherein the second type of charge carriers are different from the first type of charge carriers.

Throughout the following detailed description it is understood, that the first type of charge carriers are P-type carriers, and the second type of charge carriers are logically N-type carriers. However, the reversed configuration, wherein the first type of charge carriers are N-type carriers and the second type of charge carriers are P-type carriers is equally appliable in all examples described in this application, as both configurations (PN or NP) achieve the desired effect of creating one or both of the emitter base junctions of having a low capacitance.

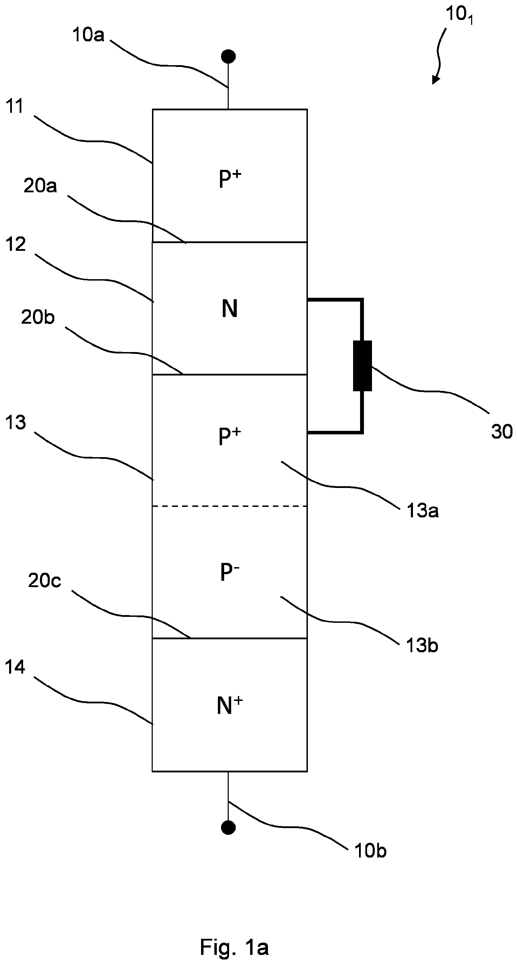

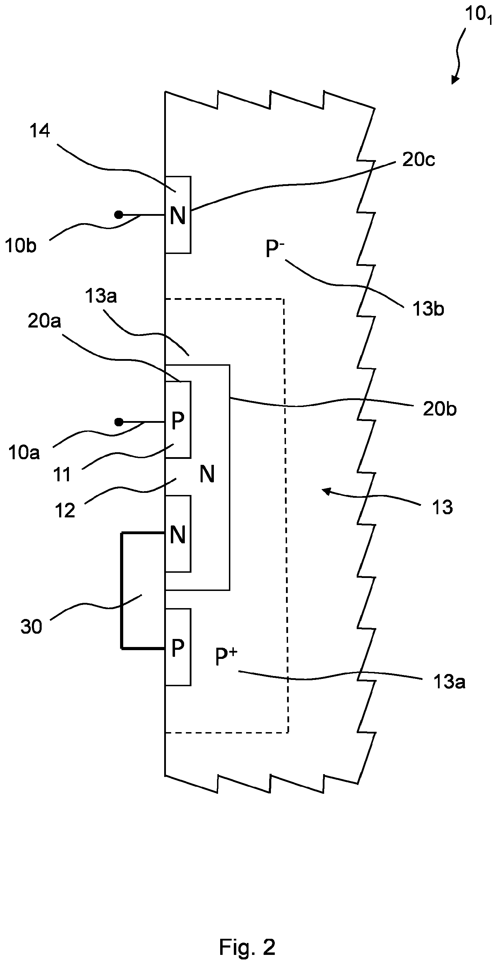

A first example of the disclosure is shown in Figures 1a-1c and 2, in a schematic view and in cross-sectional view. The first example of the semiconductor device according to the disclosure is denoted with reference numeral 10₁, and comprises a first layer 11 which is doped with a first type of charge carriers, here P-type carriers. The first layer 11 forms a first junction 20a with a second layer 12, which is doped with a second type of N-type charge carriers, which are different from the first type of P charge carriers.

Also, a third layer 13 which doped with the first type of P-type charge carriers forms a second junction 20b with the second layer, and a fourth layer 14, which is doped with the second type of N-type charge carriers forms a third junction with the third layer.

Each example depicted in this application also comprises an input terminal 10a, which is electrically connected with the first layer 11 and an output terminal 10b, which is electrically connected with the fourth layer 14.

The first layer 11, its first junction 10a, the second 12, its second junction 10b, and the third layer 13 form a first bipolar junction transistor, BJT. Similarly, the second layer 12, the second junction 10b, the third layer 13, the third junction 10c and the fourth layer 14 form a second bipolar junction transistor, BJT.

Also, reference numeral 30 denotes a junction element which electrically connects the second layer 12 with the third layer 13. The junction element 30 can be any metal functioning as an electric short between the second layer 12 with the third layer 13. As shown in Figures 1a-1c and 2, the third layer 13 comprises a region 13a which adjoins the second layer 12, which region 13a has a high dopant concentration of charge carriers. In the examples shown, the third layer 13 is doped with the first type of P-type charge carriers, and accordingly its high dopant concentration is denoted with the annotation P+.

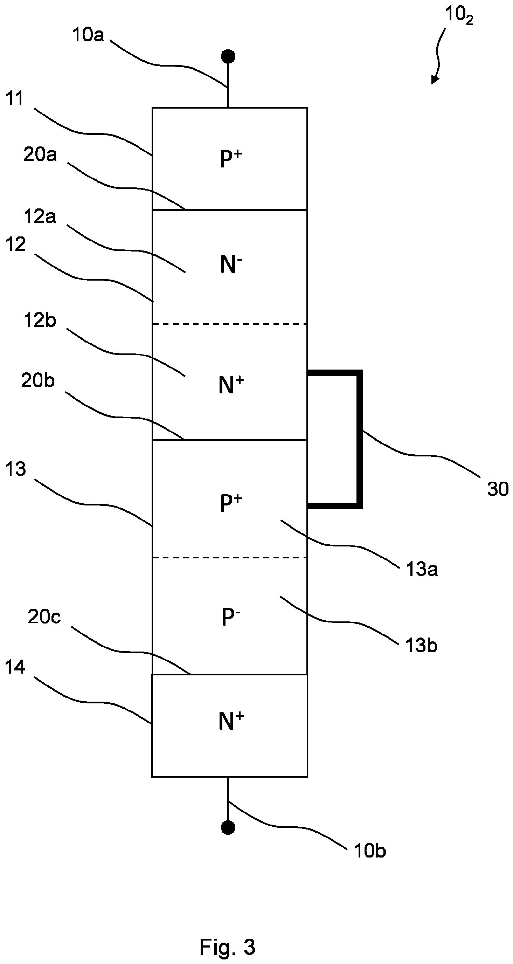

The electrical junction element 30 may function as a short between the two base contacts, formed by the second and third layers 12 and 13 respectively, of each BJT, see the example of Figure 3. It reduces the trigger voltage to the equivalent of two forward biased diodes. When the device 10₁ gets triggered, both emitter-base junctions 20a and 20c, between the first-second layers 11-12 and fourth-third layers 13-14, are forward biased at the same time. Injection of minority carriers starts from both sides via the input and output terminals 10a-10b and the turn-on effect is fast.

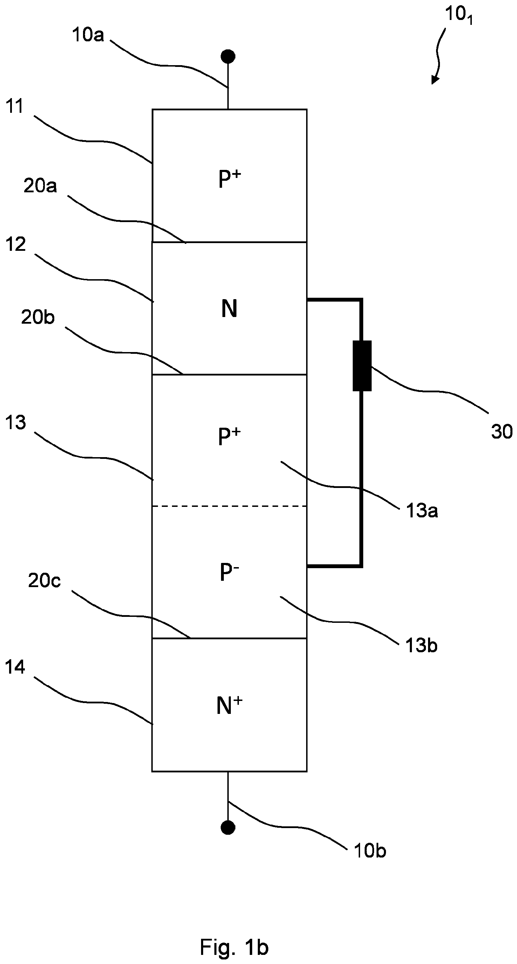

Figure 1a depicts a first configuration of the first example of the disclosure, wherein the junction element 30 electrically connects the second layer 12 with the high dopant region 13a (P+) of the third layer 13. Figure 1b depicts a second configuration of the first example of the disclosure, wherein the junction element 30 electrically connects the second layer 12 with the low dopant region 13b (P-) of the third layer 13.

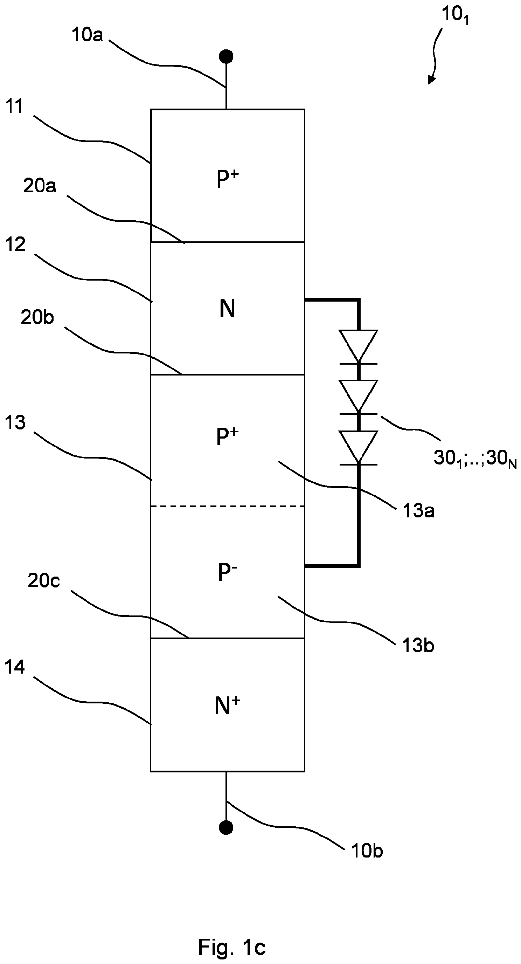

Additionally, the electrical junction element 30 may function as a resistor between the two base contacts of each BJT (see Figures 1a and 1b), or as a stack of diodes 30₁;..30_{N} connected in series, with N≥1, the latter configuration being depicted in Figure 1c and similarly electrically connecting the second layer 12 with either the high dopant region 13a (P+) or the low dopant region 13b (P-) of the third layer 13. Also a combination of a resistor and diodes connected in series is a feasible configuration.

In the example of Figures 1a-1c and 2, the emitter-base junction 20a has a low capacitance, therefore, the semiconductor controlled rectifier has a low capacitance, too.

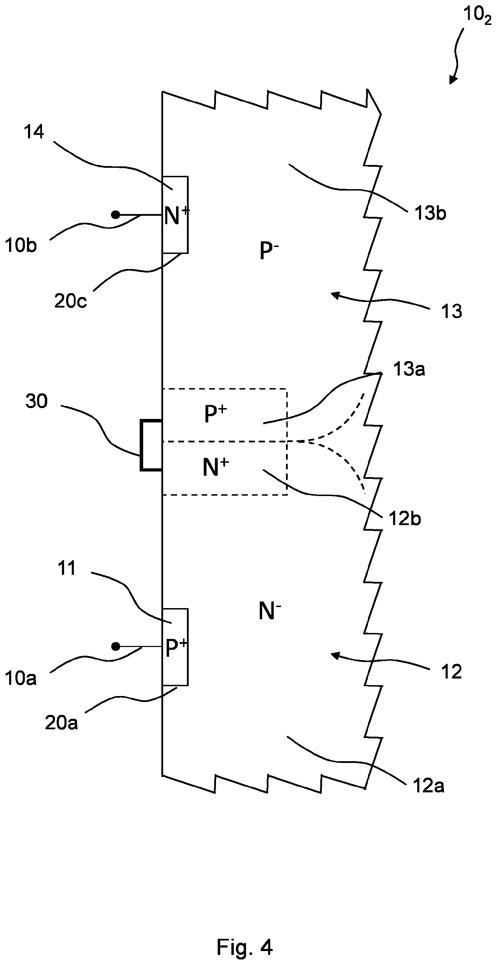

In the example of Figures 3 and 4, the third layer 13 has two dopant regions 13a and 13b. A low dopant region 13b adjoins the high dopant region 13a of the third layer 13, but as show in the Figures 3 and 4, the low dopant region 13b also adjoins the fourth layer 14 having N-type charge carriers. The doping of the high dopant region 13a is higher than the doping of the low dopant region 13b. As in these examples, the third layer 13 has P-type charge carriers, both doping are denoted with P+ (for high) and P- (for low).

Thus, the fourth layer 14, functioning as one emitter for the BJT, is electrically connected with or placed in a low doped part 13b (P-) of its adjacent base/third layer 13, as shown in Figure 4. This emitter-base junction 20c has a low capacitance, and consequentially the semiconductor controlled rectifier exhibits beneficially a low capacitance. This obviated the use of an additional trigger diode. Therefore, sophisticated isolation schemes to inhibit the parasitic interactions between the external trigger diode and the semiconductor controlled rectifier are not needed, resulting in a simplified, yet effective configuration.

In a further advantageous example, which is also depicted in Figure 3 and Figure 4, the second layer 12 also has two dopant regions 12a and 12b. A high dopant region 12b adjoins the high dopant region 13a of the third layer 13, forming the second junction 20b. The low dopant region 12a adjoins the first layer 11. Likewise it is to be noted, that the doping of the high dopant region 12b is higher than the doping of the low dopant region 12a. As in these examples, the second layer 12 has N-type charge carriers, both doping are denoted with N+ (for high) and N- (for low).

Here, both emitters formed by the first layer 11 and the fourth layer 14 are positioned in low doped base areas 12a (N-) and 13b (P-), respectively, see Figure 4. Both emitter-base junctions 20a and 20c exhibit a low capacitance, and due to the series connection of both low-capacitance emitter-base junctions, the total capacitance of the semiconductor device 10₂ is small too.

Note that the example of a semiconductor device 10₂ only implementing the third layer 13 with two dopant regions 13a (P+) and 13b (P-), and the example of a semiconductor device 10₂ implementing the third layer 13 with two dopant regions 13a (P+) and 13b (P-) as well as the second layer 12 with two dopant regions 12a (N-) and 12b (N+) are functional examples of the disclosure.

Likewise, several configurations are possible, wherein the junction element 30 electrically connects either dopant region 12a (N-) or 12b (N+) of the second layer 12 with either dopant region 13a (P+) or 13b (P-) of the third layer 13. Thus, the junction element 30 may interconnect dopant region 12a (N-) with either dopant region 13a (P+) or 13b (P-) or the junction element 30 may interconnect dopant region 12b (N+) with either dopant region 13a (P+) or 13b (P-).

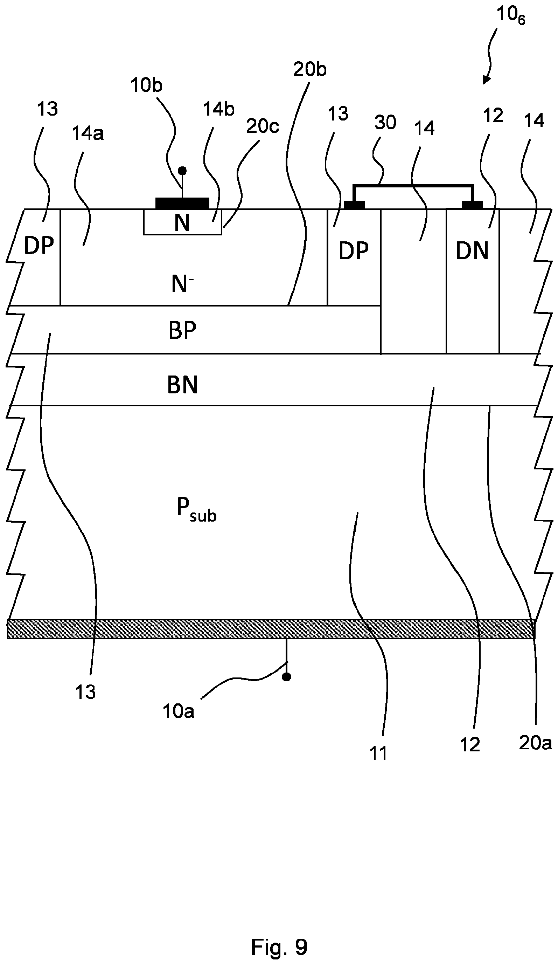

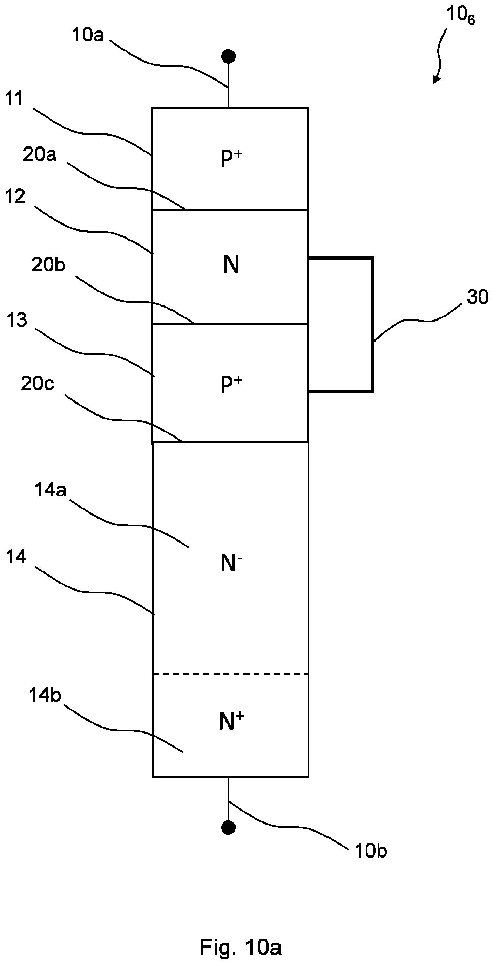

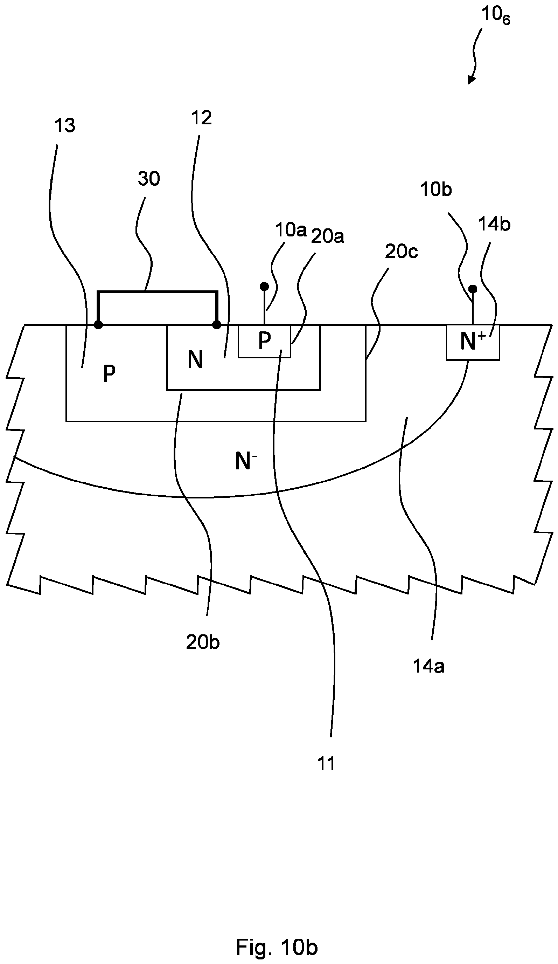

Optionally, as shown for example in Figures 1a-1c, 3 and 4 (and optionally also in the examples of Figures 10a-10b), the fourth layer 14 may comprise a high dopant concentration denoted with N+. Alternatively, in an advantageous example (see Figure 9 and 10a-10b), the fourth layer 14 is formed of a high dopant region 14b (N+) and a low dopant region 14a (N-), which functions as a depletion zone. The high dopant region 14b (N+) adjoins the output terminal 10b and the low dopant region 14a adjoins the third layer 13, in an example the low dopant region 14a (N-) adjoins the third layer 13 having a high dopant concentration P+ (see Figure 10a and 10b). Also in this example, the doping of the high dopant region 14b (N+) is higher than the doping of the low dopant region 14a (N-). The emitter-base junction (third junction 20c) thus formed also exhibits a low capacitance. The low doped region 13b (P-) is not necessarily part of the base layer 13. Comparable results are achievable with a low doped region 14a as depletion zone (N-) within the emitter/fourth layer 14.

The high doping for both the P-type charge carriers as the N-type charge carriers used may include a high dopant region (P+ or N+) having a doping greater than 1×10¹⁵ cm⁻³ and a layer thickness greater than 0.2 µm, more in particular a doping greater than 1×10¹⁶ cm⁻³ and a layer thickness greater than 1 µm. Likewise, as to the low doping for both P-type / N-type charge carriers, the low dopant region (P- or N-) may have a doping smaller than 1×10¹⁵ cm⁻³ and a layer thickness greater than 1 µm, more in particular a doping smaller than 1×10¹⁴ cm⁻³ and a layer thickness greater than > 2 µm.

In a preferred example, the first layer 11 has a doping (P+) higher than the doping of the low dopant region 13b (P-) of the third layer 13.

Further advantageous examples of the semiconductor device are shown in Figures 2, 4-7 and 9. In an example, see e.g. Figure 2, 4-9 and 10b, the fourth layer 14 is formed as a well (either as with dopant concentration N or high dopant concentration N+) in the low dopant region 13b (P-) of the third layer 13. Likewise, the high dopant region 13a (P+) of the third layer 13 may be formed as a well in the low dopant region 13b (P-) of the third layer 13, see Figure 2, 4. And the second layer 12 may be formed as a well in the high dopant region 13a (P+) of the third layer 13, see Figure 2 and 4.

The third layer 13 functions as a substrate (e.g. a P substrate) in the example 10₂ of Figure 2. The high doped (P+) well 13a is placed within the P-substrate 13 with a proper distance between the well 13a and a N+-diffusion well 14 placed in the low dopant region 13b of the substrate 13. The N+-diffusion well 14 is in turn is connected with the output terminal 10b. A N-doped well 12 is placed within the P+-well 13a. The N-well 12 and the P+-well 13a are electrically contacted and connected to each other via the junction element 30, thus forming a short. Likewise, the first layer 11 may be formed as a P+-diffusion well in the second layer 12 and connected with the input terminal 10a.

Accordingly, such semiconductor device 10₂ can be manufactured in a logical sequence of manufacturing steps as shown in Figure 2 and 4. This embodiments have additional advantages: the connection between the two bases 11 and 12 is local, and this facilitates the implementation for so-called multi-finger layouts. In the example of Figure 4, both emitters 11 and 14 can be placed in low doped base areas, denoted with N- regions 12a and P- regions13b.

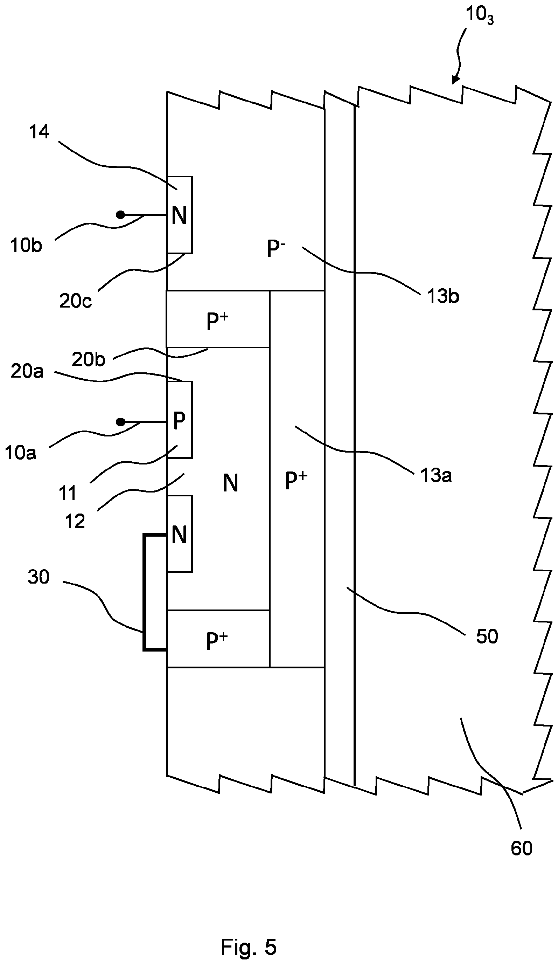

In Figure 5, another example 10₃ of a semiconductor device according to the disclosure is depicted. Reference numeral 50 denotes a buried oxide substrate implementing silicon-on-insulator, SOI, technology, and the buried oxide substrate 50 may be supported by a wafer carrier 60, e.g. made of silicon. The buried oxide substrate 50 is used as a base layer on which the third layer 13 is deposited. The third layer 13 is formed of a low dopant region (P-) 13b and an high dopant region (P+) 13a. the fourth layer 14 is formed in the low dopant region 13b, whereas the second layer 12 is formed as a well in the high dopant region 13a. The first layer 11 is formed as a well in the second layer 12. Junction element 30 shorts the second layer and the high dopant region 13a, and the first layer well 11 and the fourth layer well 14 form the input terminal 10a and output terminal 10b, respectively.

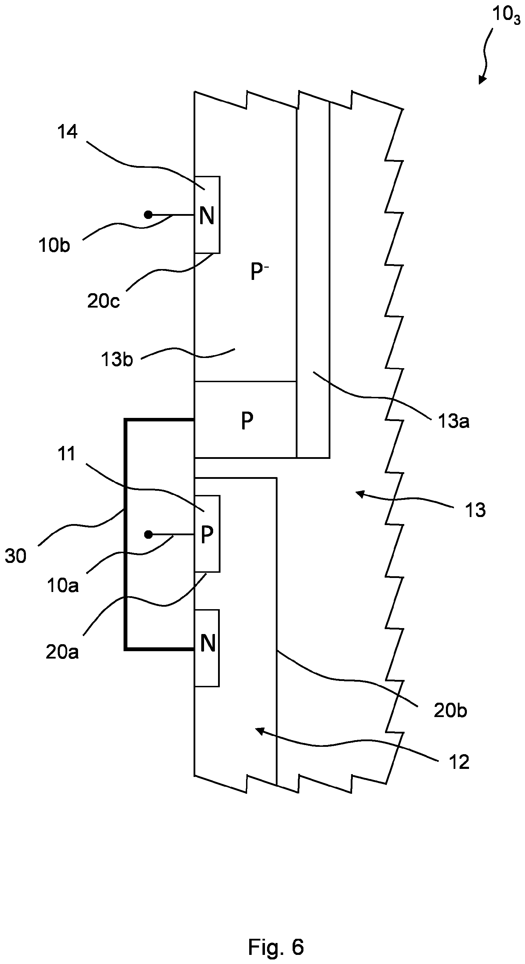

The semiconductor device 10₃ of Figure 6 realizes the anti-punch-through with a deep P-well 13a and a buried P-well 13a of high dopant (P+) surrounding the N-well 14 (the fourth layer / emitter 14). The second layer 12 is formed as a well in the low dopant (13b / P-) third layer substrate 13. The first layer 11 is formed as a well in the second layer 12. Also here, the junction element 30 shorts the second layer 12 and the high dopant region 13a.

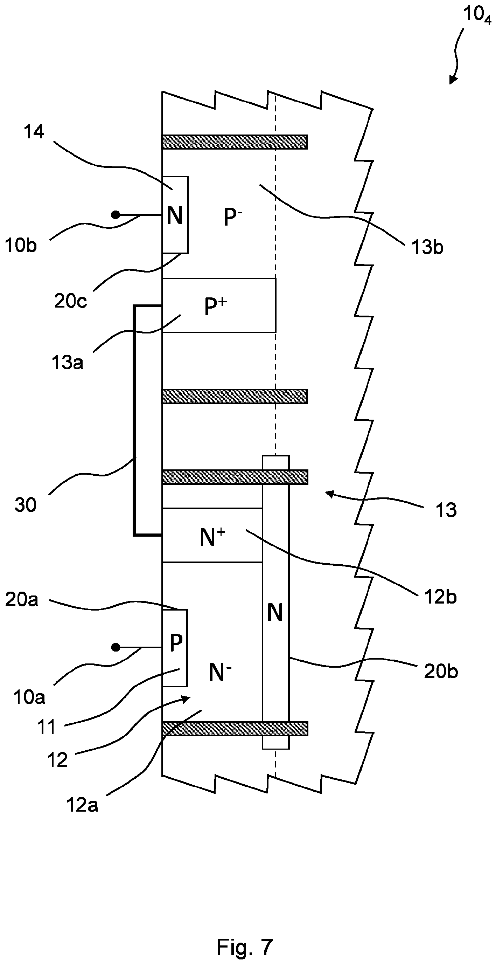

Figure 7 shows an example 10₄ of an semiconductor device according to the disclosure the first by the use of buried oxide (SOI technology). This embodiment is an example for low capacitance realized at both emitter-base junctions

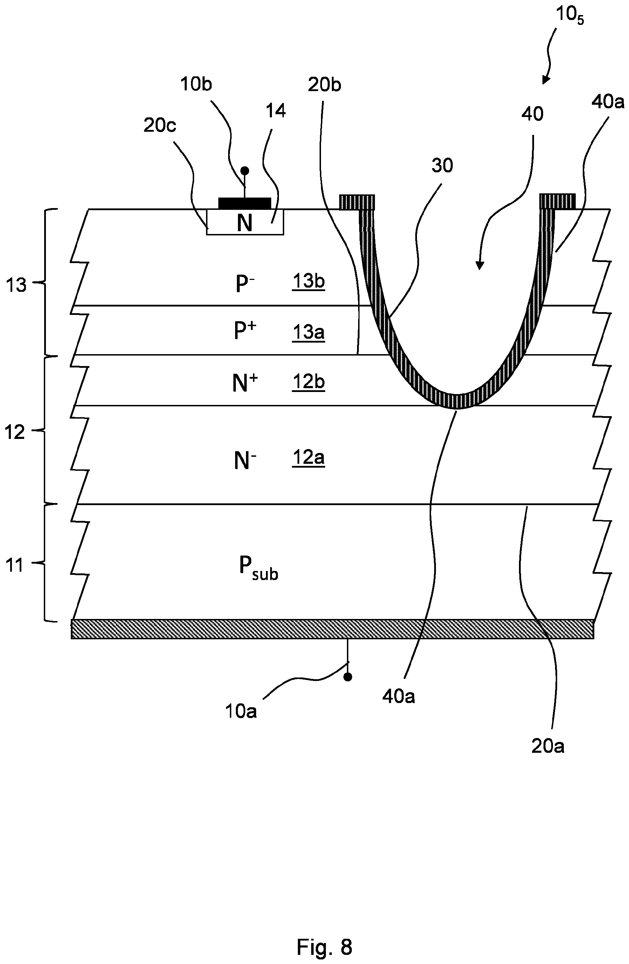

Figure 8 shows a particular example, wherein the semiconductor device 10₅ is formed of the first layer 11, the second layer 12, the third layer 13 and the fourth layer 14 being configured in a layered stack. In this example, the first layer 11 functions as a base layer or base substrate on which subsequent layers 12, 13 and 14 are mounted (through deposition or through another layering technique). Reference numeral 40 denotes a trench, which is formed in the layered stack and extends from the top, fourth layer 14, through the third layer 13 and into at least the second layer 12. Through a deposition or layering technique an electrically conductive layer 30 is coated against the side walls 40a of the trench 40, thus forming the junction element 30. In this configuration the electrically conductive layer 30 functions as an electrical short between the second layer 12 and the third layer 13.

Figure 9 depicts an example denoted with reference numeral 10₆ which can be considered as a vertical Shockley diode. Also in this example, the first layer 11 functions as a substrate (here as a P-substrate), on which substrate 11 the second layers 12 (denoted as BN layer) and 13 (denoted as the BP layer) are formed. On the BL layer 13 a fourth layer 14 is formed, through deposition or other layering technique. By means of deep N- and P-diffusions contacts (denoted with DP 13 and DN 12) are created which electrically contact the buried base diffusions (BN layer 12 and BP layer 13). Accordingly the required second layer contact 12 and the third layer contact 13 is formed, which are subsequently short-circuited by means of the electric junction element 30. Note that in this example of Figure 9, the fourth layer 14 is formed as a low dopant region 14a (N-).

In all examples shown, when a positive voltage is applied at the input terminal 10a connected with the first layer (e.g. the P+ contact), a current will flow through the first junction 20a (e.g. formed by the P+-contact 11 and the N-well 12) causing one forward voltage drop). The current subsequently flows through the N-well 12 to the N-well contact (causing a resistive voltage drop), through the junction element 30 towards the P-well contact, from the P-well contact through the P-well 13a and through the P-substrate 13 (causing a resistive voltage drop) and eventually through the substrate N+-junction 20c towards the output terminal 20b (causing another forward voltage drop).

When the current exceeds a certain limit (trigger current) then the SCR will switch to its on-state and the current will flow directly from the N+-contact 14 to the P+-contact 11. The trigger voltage is the sum of all four voltage drops at the trigger current, typically in the range of 2 Volts.

### LIST OF REFERENCE NUMERALS USED

- 10₁-10₆: semiconductor device (1^{st} - 6^{th} example of the disclosure)
- 10a: first (emitter) terminal
- 10b: second (emitter) terminal
- 11: first layer doped
- 12: second layer
- 12a: low dopant region of second layer
- 12b: high dopant region of second layer
- 13: third layer
- 13a: high dopant region of third layer
- 13b: low dopant region of third layer
- 14: fourth layer
- 14a: low dopant region of fourth layer
- 14b: high dopant region of fourth layer
- 20a-20c: first, second and third junction interface
- 30: junction element / short / resistor / trench layer coating
- 30₁..30_{N}: stack of junction elements / resistor / diodes (in series)
- 40: trench
- 40a: side wall of trench
- 50: oxide substrate
- 60: carrier wafer

## Claims

1. A semiconductor device comprising:
a first layer doped with a first type of charge carriers;
a second layer doped with a second type of charge carriers different from the first type of charge carriers;
a third layer doped with the first type of charge carriers;
a fourth layer doped with the second type of charge carriers;
an input terminal electrically connected with the first layer and an output terminal electrically connected with the fourth layer;
wherein the first, second and third layer form a bipolar junction transistor, BJT, and the second, third and fourth layer form a second bipolar junction transistor, BJT, and comprising a junction element electrically connecting the second layer with the third layer, wherein the third layer comprises a high dopant region adjoining the second layer.

2. The semiconductor device according to claim 1, wherein the third layer comprises a low dopant region adjoining the high dopant region of the third layer as well as adjoining the fourth layer, wherein the doping of the high dopant region is higher than the doping of the low dopant region.

3. The semiconductor device according to claim 1 or 2, wherein the second layer comprises a high dopant region adjoining the high dopant region of the third layer and a low dopant region adjoining the first layer, wherein the doping of the high dopant region is higher than the doping of the low dopant region.

4. The semiconductor device according to any one or more of the preceding claims, wherein the fourth layer comprises a high dopant region adjoining the output terminal and a low dopant region adjoining the third layer, wherein the doping of the high dopant region is higher than the doping of the low dopant region.

5. The semiconductor device according to any one or more of the claims 1-4, wherein the first type of charge carriers are P-type carriers and the second type of charge carriers are N-type carriers.

6. The semiconductor device according to any one or more of the claims 1-4, wherein the first type of charge carriers are N-type carriers and the second type of charge carriers are P-type carriers.

7. The semiconductor device according to any one or more of the preceding claims, wherein the high dopant region has a doping greater than 1×10¹⁵ cm⁻³ and a layer thickness greater than 0.2 µm, more in particular a doping greater than 1×10¹⁶ cm⁻³ and a layer thickness greater than 1 µm.

8. The semiconductor device according to any one or more of the preceding claims, wherein the low dopant region has a doping smaller than 1×10¹⁵ cm⁻³ and a layer thickness greater than 1 µm, more in particular a doping smaller than 1×10¹⁴ cm⁻³ and a layer thickness greater than > 2 µm.

9. The semiconductor device according to any one or more of the preceding claims, wherein the fourth layer is formed as a well in the low dopant region of the third layer.

10. The semiconductor device according to any one or more of the preceding claims, wherein the high dopant region of the third layer is formed as a well in the low dopant region of the third layer.

11. The semiconductor device according to any one or more of the preceding claims, wherein the second layer is formed as a well in the high dopant region of the third layer.

12. The semiconductor device according to any one or more of the preceding claims, wherein the first layer is formed as a well in the second layer.

13. The semiconductor device according to any one or more of the claims 1-12, wherein the first layer has a doping higher than the doping the low dopant region of the third layer.

14. The semiconductor device according to any one or more of the claims 1-13, further comprising an oxide substrate on which the third layer is deposited.

15. The semiconductor device according to any one or more of the claims 1-14, wherein the first, second, third and fourth layer are configured in a layered stack and wherein a trench is formed in the layered stack from the fourth layer into at least the second layer, and wherein the junction element is configured as an electrically conductive layer coating the trench.
